# EUROPÄISCHE PATENTSCHRIFT

(11) **EP 2 032 734 B1**
(45) Veröffentlichungstag und Bekanntmachung des Hinweises auf die Patenterteilung: **30.03.2011**
(21) Anmeldenummer: 07764928.3
(22) Anmeldetag: 28.06.2007
(51) Int. Cl.: C23C 14/00, C23C 14/06, C23C 14/08

(54) **VERFAHREN ZUR HERSTELLUNG EINES BESCHICHTETEN GEGENSTANDS DURCH SPUTTERN EINES KERAMISCHEN TARGETS**
METHOD FOR THE PRODUCTION OF A COATED OBJECT BY SPUTTERING A CERAMIC TARGET
PROCÉDÉ DE RÉALISATION D'UN OBJET REVÊTU PAR PULVÉRISATION D'UNE CIBLE CÉRAMIQUE

(30) Priorität: 28.06.2006 DE 102006029683; 28.09.2006 DE 102006046126
(43) Veröffentlichungstag der Anmeldung: 11.03.2009
(73) Patentinhaber: INTERPANE Entwicklungs- und Beratungsgesellschaft mbH & Co. KG, D-37697 Lauenförde (DE)
(72) Erfinder: SEVERIN, Daniel, 63477 Maintal (DE); WUTTIG, Matthias, 52074 Aachen (DE); HERLITZE, Lothar, 37691 Derental (DE); WEIS, Hansjörg, 37671 Höxter (DE)
(74) Vertreter: Beder, Jens
(86) Internationale Anmeldenummer: PCT/EP2007/005750
(87) Internationale Veröffentlichungsnummer: WO 2008/000487

(56) Entgegenhaltungen:
- EP-B1- 1 140 721
- KARANTH S ET AL: "Effect of high-energy electron-beam irradiation on the optical properties of ion-beam-sputtered silicon oxynitride thin films" APPLIED OPTICS OPT. SOC. AMERICA USA, Bd. 44, Nr. 29, 10. Oktober 2005 (2005-10-10), Seiten 6186-6192, XP002455173 ISSN: 0003-6935

## Beschreibung

Die Erfindung betrifft ein Verfahren zur Herstellung eines beschichteten Gegenstands durch Sputtern eines keramischen Targets und einen so hergestellten Gegenstand.

Zur Beschichtung von Gegenständen, wie beispielsweise Gläsern bei der Herstellung von Isolierverglasungen, wird üblicherweise das sogenannte Kathodenzerstäuben (Sputtern) eingesetzt. Aus einem leitfähigen Material, welches als Target bezeichnet wird, wird durch Ionenbeschuss Material abgetragen. Dieses Material kondensiert auf einer Oberfläche eines in der Nähe angeordneten Substrats und bildet somit eine dünne Schicht auf der Substratoberfläche. Bei vielen Anwendungen ist es erforderlich auf der Substratoberfläche eine Metalloxidschicht anzuordnen. Solche Metalloxidschichten werden beispielsweise häufig als Antireflexschichten in Beschichtungen für Wärmeschutzverglasungen verwendet.

Zum Aufbringen der Schichten ist es aus der EP 0 795 623 A1 bekannt, in einer reaktiven Prozessatmosphäre von einem metallischen Target Material abzusputtern (zu zerstäuben). In Abhängigkeit von dem Reaktivgas, das z.B. Sauerstoff, Stickstoff und Kohlenstoff enthält, bildet sich eine Schicht der Zusammensetzung MeOₓN_{y}C_{z} auf der Substratoberfläche aus. Der Sauerstoff-, Stickstoff- und Kohlenstoffgehalt in der Schicht auf der Substratoberfläche steht dabei in einem Zusammenhang mit den Anteilen der entsprechenden Gase in dem Prozessgas. Da einige Prozessparameter empfindlich von der Zusammensetzung des Gases abhängen, wird zur Steuerung des Prozesses der Gasfluss des Prozessgases reguliert. Hierzu werden schnelle Gasdurchflusswächter oder Ventile so angesteuert, dass sich die erwünschten Schichteigenschaften einstellen. In einem sogenannten Hysteresebereich muss zum Erzielen einer hohen Depositionsrate bei gleichzeitig transparenter aufgetragener Schicht das Target als Kathode in einem eigentlich instabilen Bereich betrieben werden.

Auch aus der WO 01/73151 A1 ist es bekannt, den Sauerstofffluss bzw. den Sauerstoffpartialdruck während des Abscheidevorgangs zu regeln, um ein stöchiometrisches Oxid auf dem Substrat abzuscheiden. Es kommt jedoch aufgrund der komplexen Zusammenhänge bei Änderungen einzelner Beschichtungsparameter, wie beispielsweise dem Sauerstoffgehalt in dem Prozessgas, zu einer gegenseitigen Beeinflussung mit anderen Parametern, so dass das Einstellen eines stabilen Arbeitspunktes äußerst schwierig ist. Da der Prozess zum Erreichen wirtschaftlich interessanter Depositionsraten in einem instabilen Hysteresebereich ablaufen muss, kann es bei einer schnellen Reaktivgasregelung zu einem Herauskippen des Prozesses aus diesem Hysteresebereich kommen. Damit ändern sich die Rate und die gewünschte Schichtdicke ebenso wie die Interferenzfarbe der Beschichtung. Insbesondere bei wechselnder Substratbelegung ist die Reaktivgasregelung kritisch, da sich bei einem Wechsel der Substratbelegung der Reaktivgasdruck durch die Änderung der Pumpgeometrie rasch ändern kann und somit ein plötzliches Verlassen des eingestellten Prozessfensters auftreten kann.

Aus der EP 1 140 721 B1 ist zudem bekannt, zum Auftragen von Metalloxidschichten sauerstoffhaltige keramische Targetmaterialien zu verwenden. Diese keramischen Targetmaterialien enthalten neben dem Metall, welches Basis für das abzuscheidende Metalloxid ist, bereits einen Sauerstoffanteil. Aufgrund des Sauerstoffanteils in dem Targetmaterial kann das Prozessgas einen geringeren Sauerstoffanteil enthalten. Durch den Sauerstoffanteil in dem Target ist jedoch die untere Grenze des Metall-Sauerstoffgemisches bereits durch das Target festgelegt. Dies erschwert oder verhindert die Herstellung von substöchiometrischen oxidischen Schichten, die bei bestimmten Anwendungen vorteilhaft sind. - Sowohl bei der Verwendung sauerstoffhaltiger keramischer Targets als auch bei der Verwendung von metallischen Targets in einer sauerstoffhaltigen Sputteratmosphäre ist es nachteilig, dass sogenanntes Bombardement der Substratoberfläche mit energiereichen Sauerstoffatomen zu einer unerwünschten Beeinflussung der Struktur in der abgeschiedenen Metalloxidschicht führt. Während im Falle sauerstoffhaltiger keramischer Targets unmittelbar aus dem Targetmaterial stammender Sauerstoff durch den Ionenbeschuss während des Sputtervorgangs beschleunigt wird und somit mit hoher kinetischer Energie auf die Substratoberfläche prallt, neigen rein metallische Targets in einer Sauerstoffatmosphäre dazu, an ihrer Oberfläche Sauerstoff anzulagern. Dieser dort angelagerte Sauerstoff wird dann wiederum durch den Ionenbeschuss herausgelöst und trifft mit hoher kinetischer Energie auf die Substratoberfläche. Dieses sogenannte Bombardement führt in beiden Fällen zu dem unerwünschten Auftreten von Spannungen in der abgeschiedenen Schicht. Solche Spannungen wirken sich nachteilig sowohl auf die chemische Stabilität als auch die mechanische Widerstandsfähigkeit aus. Dies betrifft insbesondere auch nachfolgend aufgebrachte Schichten, welche auf einer solchen Antireflexschicht aufgetragen werden.

Das Dokument KARANTH S ET AL: "Effect of high-energy electron-beam irradiation on the optical properties of ion-beam-sputtered silicon oxynitride thin films" APPLIED OPTICS OPT. SOC. AMERICA USA, Bd. 44, Nr. 29, 10. Oktober 2005 (2005-10-10), offenbart auf den Seiten 6186-6192 und insbesondere auf Seite 6187 ein Verfahren zum Herstellen eines beschichteten Gegenstands mittels Kathodenzerstäuben durch Abscheiden zumindest einer Metalloxidschicht auf einem Substrat, wobei eine sauerstoffhaltige Sputteratmosphäre erzeugt wird und Siliziumoxid durch Sputtern eines stickstoffhaltigen keramischen Targets Si3N4 in der sauerstoffhaltigen Sputteratmosphäre.

Es ist daher die Aufgabe der Erfindung, ein Verfahren zu schaffen, welches ein vereinfachtes Abscheiden von Metalloxidschichten auf einem Substrat zum Herstellen beschichteter Gegenstände schafft, wobei eine vereinfachte Prozessführung erreicht wird sowie einen mit diesem Verfahren hergestellten Gegenstand zu schaffen.

Die Aufgabe wird durch das erfindungsgemäße Verfahren mit den Merkmalen des Anspruchs 1 gelöst.

Erfindungsgemäß wird zum Herstellen eines beschichteten Gegenstands zumindest eine Metalloxidschicht auf einem Substrat abgeschieden. Zum Abscheiden des Substrats wird eine sauerstoffhaltige Sputteratmosphäre erzeugt. In dieser sauerstoffhaltigen Sputteratmosphäre wird die Metalloxidschicht durch Sputtern eines stickstoffhaltigen keramischen Targets abgeschieden. Durch die Verwendung des keramischen, stickstoffhaltigen Targets wird dabei nicht nur das Bombardement verhindert, da weder in dem Targetmaterial unmittelbar Sauerstoff enthalten ist noch sich der Sauerstoff an der Oberfläche des Targets anlagern kann, sondern es wird auch gleichzeitig das unerwünschte Arcing während eines Sputterprozesses vermindert oder vollständig verhindert. Dabei hat sich überraschender Weise herausgestellt, dass bei Verwendung von stickstoffhaltigen keramischen Targets in einer sauerstoffhaltigen Atmosphäre das Abscheiden von Metalloxidschichten auf dem Substrat möglich ist. Bei der Erzeugung der Metalloxidschicht wird in dem Prozessgas enthaltener Sauerstoff in die Schicht eingelagert. Im Rahmen der Erfindung wird unter der Bezeichnung "Metalloxidschicht" eine überwiegend oxidische Schicht auf Basis des Metalls des Targets verstanden. Überwiegend oxidisch sind dabei solche Schichten, bei denen wenigstens 50 % des Sauerstoffs, der zum Erzeugen einer stöchiometrischen Metalloxidschicht erforderlich wäre, in der Schicht enthalten ist.

Bei dem erfindungsgemäßen Verfahren ist es vorteilhaft, dass der in dem Target enthaltene Stickstoff bewirkt, dass die Metallatome an der Targetoberfläche größtenteils bereits durch Stickstoffbindungen abgestättigt sind. Es verbleiben somit nur wenige freie Metallatome, die den in dem Reaktivgas zugemischten Sauerstoff aufnehmen könnten. Infolgedessen sinkt die Neigung zu Arcing und das Bombardement der Substratoberfläche wird reduziert. Damit kann ein relativ hoher Sauerstofffluss eingestellt werden und des Hystereseverhalten wird deutlich abgemildert. Da ein hoher Sauerstofffluss eingestellt werden kann, wird trotz des in dem Targetmaterial vorhandenen Stickstoffs auf dem Substrat eine überwiegend oxidische Schicht abgeschieden, welche optisch transparent ist. Vorteilhafte Ausführungsformen ergeben sich aus den Unteransprüchen.

So ist es insbesondere vorteilhaft, die Metalloxidschicht, welche erfindungsgemäß aus dem stickstoffhaltigen, keramischen Target abgeschieden wird, als Antireflexschicht vorzusehen, wobei es insbesondere vorteilhaft ist, eine solche Antireflexschicht unterhalb und/oder oberhalb einer Infrarot reflektierenden Funktionsschicht anzuordnen. Die Begriffe "unterhalb" und "oberhalb" beziehen sich dabei auf die Anordnung des Schichtsystems auf einem Substrat. Dabei wird die angrenzend an das Substrat aufgetragene Schicht als unterste Schicht bezeichnet. Die nachfolgenden Schichten werden somit "oberhalb" dieser untersten Schicht angeordnet.

Besonders bevorzugt ist es, den Sauerstofffluss in der Beschichtungskammer so einzustellen, dass sich in der Metalloxidschicht ein Atomverhältnis von Sauerstoff zu Stickstoff von mindestens 5 einstellt. Damit ist gewährleistet, dass die abgeschiedene Metalloxidschicht auf dem Substrat die erforderlichen optischen Eigenschaften insbesondere hinsichtlich ihrer Transparenz im sichtbaren Bereich erfüllt. Aufgrund des abgemilderten Hystereseverlaufs kann bei dem erfindungsgemäßen Verfahren dabei der Sauerstofffluss solange erhöht werden, bis sich eine solche Schichtausbildung auf dem Substrat ergibt. Dabei muss, wegen der vorstehend bereits genannten Effekte, nicht befürchtet werden, dass der Prozess instabil wird.

Insbesondere ergeben sich die Vorteile bei Verwendung von stickstoffhaltigen keramischen Targets eines der Elemente Ti, Zn, Zr, Hf, Nb, Si, Al oder einer Mischung hiervon.

Eine besonders stabile Prozessführung lässt sich einstellen, wenn das keramische Target eine Zusammensetzung von MeNᵤ aufweist, wobei u mindestens 0,2 und höchstens 1,2 ist.

Insbesondere bei der Verwendung von TiNᵤ Targets ist es vorteilhaft, wenn u zwischen 0,2 und 1,2 ist, wobei aus dem stickstoffhaltigen, keramischen Titannitridtarget eine Metalloxidschicht mit der Zusammensetzung TiOₓN_{y} mit x ≥ 1,8 und y ≤ 0,2 abgeschieden wird. Besonders bevorzugt wird hieraus eine Schicht mit der Zusammensetzung x ≥ 1,9 und y ≤ 0,1 abgeschieden. Die Reaktion mit dem Sauerstoff in der Prozessatmosphäre lässt sich vorzugsweise durch Erhöhen des Sauerstoffflusses in der Atmosphäre verbessern. Damit führen erhöhte Sauerstoffflüsse in der Beschichtungskammer zum Abscheiden von oxidischen Metallschichten mit höherem Sauerstoffgehalt auf dem Substrat.

Vorteilhafte Ausführungsformen sind in der Zeichnung dargestellt und werden in der nachfolgenden Beschreibung näher erläutert. Es zeigen:
- Fig. 1: einen beispielhaften Aufbau für ein mit dem erfindungsgemäßen Verfahren erzeugtes Schichtsystem;
- Fig. 2: eine stark vereinfachte Darstellung einer Beschichtungskammer zur Durchführung des erfindungsgemäßen Verfahrens;
- Fig. 3: ein Vergleich der Prozessparameter zum Erzeugen von Metalloxidschichten zwischen metallischen Targets und stickstoffhaltigen keramischen Targets;
- Fig. 4: ein weiterer Vergleich der Prozessparameter beim Erzeugen von Metalloxidschichten mittels eines metallischen Targets und eines stickstoffhaltigen keramischen Targets; und
- Fig. 5: eine schematische Darstellung zur Verdeutlichung des Einflusses des verwendeten Targets auf die erzeugten Strukturen einer abgeschiedenen Zirkonoxidschicht.

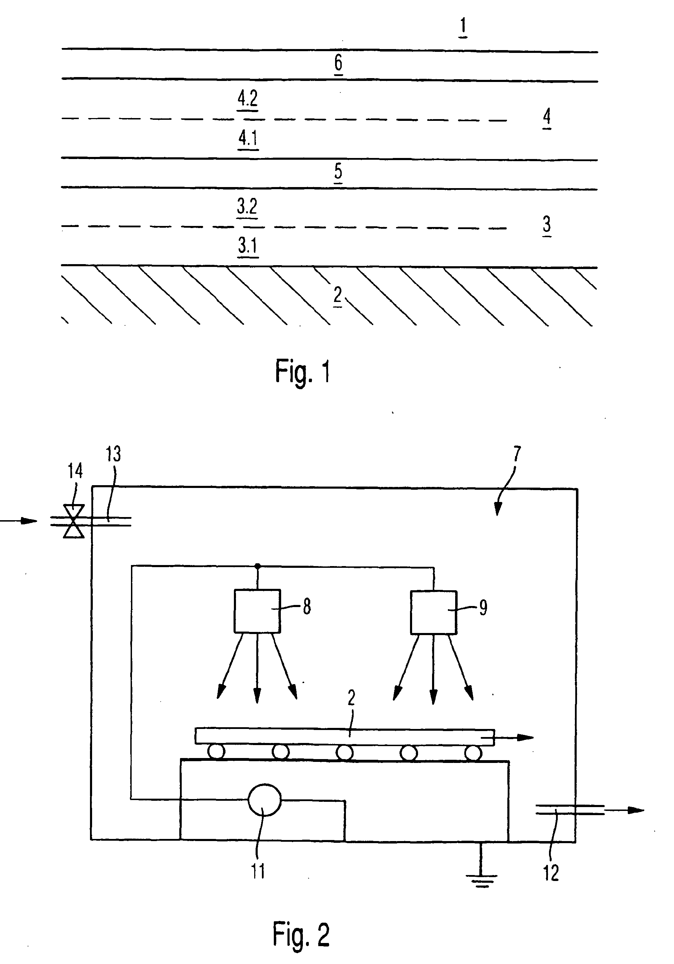

In der Fig. 1 ist beispielhaft ein Schichtsystem dargestellt, wie es für Wärmeschutzverglasungen eingesetzt wird. Die Erzeugung eines beschichteten Gegenstands mit dem erfindungsgemäßen Verfahren ist nicht nur auf das Erzeugen solcher Schichtsysteme für Wärmeschutzverglasungen beschränkt. Vielmehr sind auch andere Schichtsysteme, bei denen eine Metalloxidschicht zum Einsatz kommt, durch das erfindungsgemäße Verfahren erzeugbar. Beispielsweise werden Entspiegelungsschichten oder Teilschichten eines Metalloxids für Schichtsysteme bei Brillengläsern, Fensterverglasungen, Schaufenstern, Solarzellen, Abdeckgläsern für fotovoltaische oder solarthermische Anwendungen eingesetzt. Auch Architekturgläser in Wärmeschutz- oder Sonnenschutzschichten oder hochreflektierende Einzelschichten sind mit dem erfindungsgemäßen Verfahren herstellbar.

In der Fig. 1 ist ein Schichtsystem 1 dargestellt, welches besonders vorteilhaft mit dem erfindungsgemäßen Verfahren hergesellt wird. Das Schichtsystem 1 wird auf einem Substrat 2 angeordnet. Das Substrat 2 kann beispielsweise ein Floatglas sein. Ebenso sind andere Substratmaterialien wie beispielsweise Plexiglas denkbar.

Auf dem Substrat 2 wird zunächst eine erste Entspiegelungs- oder Antireflexschicht 3 angeordnet. Das Schichtsystem 1 weist ferner eine zweite Antireflexschicht 4 auf. Die Antireflexschichten 3, 4 schließen eine Infrarot reflektierende Schicht 5 sandwichartig ein. Die Infrarot reflektierende Schicht 5 ist eine dünne metallische Schicht, wobei insbesondere Silber als Infrarot reflektierende Schicht eingesetzt wird. Die Infrarot reflektierende Schicht 5 bildet in dem Schichtsystem 1 eine Funktionsschicht. Je nach Einsatzgebiet des verwendeten Schichtsystems, also der Reflexion in bestimmtem Wellenlängenbereichen kann diese Funktionsschicht unterschiedliche Ausprägungen haben. Das dargestellte Ausführungsbeispiel betrifft eine sogannten Low E-Beschichtung, wie sie bei Wärmeschutzverglasungen eingesetzt wird.

Wie dies durch die gestrichelte Linie in der ersten Antireflexschicht 3 und der zweiten Antireflexschicht 4 gezeigt ist, können die Antireflexschichten, welche oberhalb und unterhalb der Infrarot reflektierenden Schicht 5 angeordnet sind, mehrere Teilschichten 3.1 und 3.2 bzw. 4.1 und 4.2 umfassen. Der Schichtaufbau der Antireflexschichten ist nicht auf die dargestellte zweilagige Anordnung beschränkt. Insbesondere sind zum Aufbau selektiver Schichtsysteme weitere Schichten denkbar. Dabei kann auf einer Seite oder auf beiden Seiten der Silberschicht eine Haftschicht zum Verbessern der Beständigkeit angeordnet sein.

Um den gesamten Schichtstapel vor Witterungseinflüssen oder während der Weiterverarbeitung des beschichteten Gegenstands zu schützen, wird abschließend eine Schutzschicht 6 auf dem Schichtstapel aufgetragen und damit des Schichtsystem 1 komplettiert.

In dem dargestellten Ausführungsbeispiel ist lediglich eine einzelne Infrarot reflektierende Schicht 5 vorgesehen. Es sind jedoch ebenso Schichtsysteme denkbar, die eine Mehrzahl und dann insbesondere dünnere Infrarot reflektierenden Schichten enthalten. Die mehreren Infrarot reflektierenden Schichten werden dann vorzugsweise jeweils durch mindestens eine Antireflexschicht voneinander getrennt, wobei abschließend auf der äußersten Infrarot reflektierenden Schicht vor dem Abscheiden der Schutzschicht eine letzte Antireflexschicht angeordnet ist.

Das erfindungsgemäße Verfahren wird insbesondere bevorzugt angewendet, um die zweite Teilschicht 3.2 der ersten Antireflexschicht 3 und die erste Teilschicht 4.1 der zweiten Antireflexschicht 4 oberhalb bzw. unterhalb der Infrarot reflektierenden Schicht 5 abzuscheiden. Damit lässt sich die hohe mechanische und chemische Stabilität der aus dem stickstoffhaltigen keramischen Target abgeschiedenen Metalloxidschicht ausnutzen. Diese bildet eine Diffusionssperre gegen Alkali-Ionen und Sauerstoff.

Durch das Verwenden eines stickstoffhaltigen keramischen Targets werden außerdem mechanische Verspannungen durch Reduktion des Bombardements während des Abscheideprozesses verringert. Somit wird in dem gesamten Schichtsystem 1 die Gesamtverspannung reduziert und damit die Haft-, Abriebsund Waschbeständigkeit des Schichtsystems 1 verbessert. Insbesondere spannungsfrei aufgebrachte Zinkoxidschichten eignen sich z. B. als Aufwachsschicht für Silberschichten. Das erfindungsgemäße Verfahren wird daher insbesondere zur Abscheidung von Zinkoxid oder Zirkoniumoxidschichten eingesetzt. Diese sorgen für einen geringeren Flächenwiderstand der aufgewachsenen Silberschicht.

In der Fig. 2 ist stark vereinfacht eine Beschichtungsanlage zur Durchführung des erfindungsgemäßen Verfahrens dargestellt. In einer Beschichtungskammer 7, welche evakuiert ist, wird ein Substratmaterial 2 angeordnet. In dem dargestellten Ausführungsbeispiel wird das Substratmaterial 2 an einem ersten Target 8 und einem zweiten Target 9 vorbeigeführt, so dass ein gleichmäßiger Schichtauftrag gewährleistet wird. Zum Steuern des Sputtervorgangs wird eine Spannungsquelle 11 mit den beiden Targets 8, 9 und einem auf Massepotential liegenden Anlagengehäuse verbunden, so dass zwischen den Targets 8, 9 und dem Substratmaterial 2 eine Potentialdifferenz erzeugt wird. Im dargestellten Ausführungsbeispiel ist die Spannungsquelle 11 als Gleichspannungsquelle ausgeführt. Ebenso ist jedoch auch ein Wechselspannungsprozess durchführbar. Eine Wechselspannungsquelle wird dann zwischen den beiden Targets 8, 9 angeordnet. Zum Erzeugen der notwendigen Prozessatmosphäre der Beschichtungskammer 7 wird über einen Evakuierungsanschluss 12 das in der Beschichtungskammer 7 befindliche Gas durch eine nicht dargestellte Pumpe abgesaugt. Über eine oder mehrere Gaseinlässe 13 wird durch ein Ventil 14 gesteuert eine bestimmte Prozessgaszusammensetzung in der Beschichtungskammer 7 erzeugt. Die Zusammensetzung des Prozessgases hängt dabei von der Zusammensetzung des Targetmaterials der Targets 8 und 9 sowie von der gewünschten Zusammensetzung in der Metalloxidschicht auf dem Substrat 2 ab.

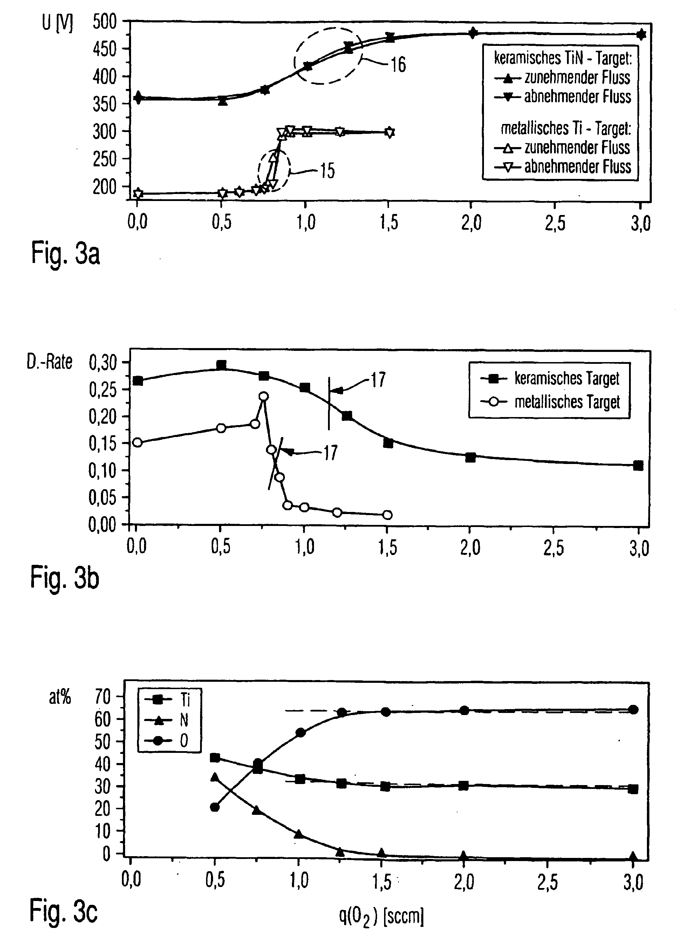

In der Fig. 3 ist der Abscheideprozess für eine Metalloxidschicht mit dem erfindungsgemäßen Verfahren im Vergleich zu einem Sputterprozess eines metallischen Targets in einer sauerstoffhaltigen Atmosphäre zum Erzeugen einer Metalloxidschicht dargestellt. In der Fig. 3a ist das Hystereseverhalten sowohl für die Verwendung eines metallischen Targets als auch für die Verwendung eines stickstoffhaltigen keramischen Targets dargestellt. Es ist zu erkennen, dass in beiden Fällen mit zunehmendem Sauerstofffluss in der Beschichtungskammer 7 ein Anstieg der eingesetzten Leistung erforderlich ist. Die ansteigende und die abfallende Flanke sind gegeneinander verschoben. Man spricht in diesem Zusammenhang von Hysterese. Es ist gut zu erkennen, dass das Hystereseverhalten im Falle des keramischen TiN-Targets deutlich weniger ausgeprägt ist als bei der Verwendung eines metallischen Titantargets. Dies ist insbesondere deswegen von Bedeutung, da gerade in diesem Bereich, welcher in der Fig. 3a mit 15 für das metallische Ti-Target angegeben ist bei wirtschaftlich interessanten Depositionsraten noch eine transparente Schicht erzeugbar ist.

Dagegen ist bei Verwendung des keramischen TiN-Targets das Hystereseverhalten in dem Bereich 16, in dem der Übergang von transparenten zu absorbierenden Schichten stattfindet, wesentlich weniger stark ausgeprägt. Zudem ist der Verlauf der Kurven für das keramische TiN-Target erheblich flacher, so dass sich Änderungen in den Prozessparametern weniger stark auswirken.

In der Fig. 3b ist die Depositionsrate sowohl für ein metallisches Target als auch für ein keramisches, stickstoffhaltiges Target angegeben. Die Grenzlinie 17 gibt dabei etwa die Grenze an, bis zu welchem Sauerstofffluss in der Beschichtungskammer 7 absorbierende Schichten aufgetragen werden. Wird der Sauerstofffluss darüber hinaus erhöht, so werden transparente Schichten abgeschieden, wie sie zum Erzeugen einer Antireflexschicht erforderlich sind, allerdings sinkt dabei gleichzeitig die Depositionsrate. Auch in der Fig. 3b ist es deutlich zu erkennen, dass der Übergang zwischen absorbierenden und transparenten Schichten in einem steilen, abfallenden Bereich liegt, wenn ein metallisches Target verwendet wird.

Der Verlauf der Depositionsrate bei der Verwendung eines stickstoffhaltigen, keramischen Targets ist dagegen insgesamt höher und insbesondere im Übergangsbereich von absorbierenden zu optisch transparenten Schichten wesentlich flacher. Zusammen mit dem verbesserten Hystereseverhalten ergibt es sich daraus, dass die Einstellung eines stabilen Arbeitspunktes für ein stickstoffhaltiges, keramisches Target wesentlich einfacher möglich ist als für ein metallisches Target. Insbesondere ist es möglich, den Sauerstoffgehalt relativ weit zu reduzieren, was zu einer Erhöhung der Abscheiderate führt.

Gleichzeitig bleibt der Prozess stabil, da aufgrund des gemäßigten Zusammenhangs mit dem Sauerstofffluss ein plötzliches Herauskippen aus dem Prozessfenster während des Prozesses nicht zu erwarten ist, sofern lediglich kleinere Schwankungen in dem Sauerstofffluss auftreten. Anders kann bei Verwendung eines metallischen Titantargets bereits eine geringe Änderung des Sauerstoffflusses zu einem Herauskippen des Prozesses aus dem Prozessfenster führen, da der sprunghafte Anstieg der Depositionsrate unmittelbar mit dem Übergang zu absorbierenden Schichten einhergeht.

In der Fig. 3c ist die Zusammensetzung der erhaltenen Metalloxidschicht auf dem Substrat 2 dargestellt. Als überwiegend oxidische Schicht wird eine Metalloxidschicht bezeichnet, bei der das Atomverhältnis von Sauerstoff zu Stickstoff größer als 3, insbesondere größer als 5 ist. Bei einem Atomverhältnis von Sauerstoff zu Stickstoff von mindestens 5 ist es gewährleistet, dass optisch transparente Schichten auf dem Substrat abgeschieden werden, welche in optischen Schichtsystemen 1 als Antireflexschichten 3, 4 einsetzbar sind.

Es ist gut zu erkennen, dass mit zunehmendem Sauerstofffluss in der Beschichtungskammer 7 trotz des Vorhandenseins von Stickstoff in dem Target das Einlagern von Stickstoff in der abgeschiedenen Schicht asymptotisch in Richtung 0 abnimmt, während der Sauerstoffanteil stark steigt. Das Vorhandensein des Stickstoffs in dem Target verschlechtert somit die optischen Schichteigenschaften nicht, begünstigt aber den Sputterprozess durch das Verhindern von Arcing ebenso wie durch die Reduzierung von Bombardement mit schnellen Sauerstoffatomen erheblich.

In der Fig. 3 ist zu erkennen, dass die auf die eingesetzte Leistung normierte Rate beim Sputtern von nitridischen Targets im Vergleich zum Sputtern von metallischen Targets etwa im Verhältnis 22 zu 15 liegt, wenn man die ersten transparent abgeschiedenen Schichten, welche in den Figuren 3a, 3b der ersten jeweils rechts der Grenzlinie 17 liegenden Proben miteinander vergleicht. Bei metallischen Targets ist aufgrund des steilen Anstiegs der negativen Targetspannung mit zunehmendem Sauerstoffanteil in der Prozessatmosphäre und einer versetzten, ebenfalls steilen Abnahme der negativen Targetspannung bei abnehmendem Sauerstoffgehalt die Einstellung eines stabilen Arbeitspunkts schwierig. Zum Erzielen sinnvoller Abscheideraten ist jedoch die Einstellung eines Arbeitspunkts gerade in diesem Bereich erforderlich.

Ein Vergleich der Figuren 3a, b und c zeigt, dass für keramische, nitridische Targets höhere Sauerstoffanteile in dem Sputtergas möglich sind, wobei die Abscheiderate deutlich weniger negativ beeinflusst wird als bei einem metallischen Target. Daraus ergeben sich hohe Abscheideraten, wobei gleichzeitig sichergestellt werden kann, dass die aufgewachsene Schicht transparent ist. Die Fig. 3c zeigt, dass die abgeschiedene Schicht überwiegend als oxidische Schicht aufgebracht wird.

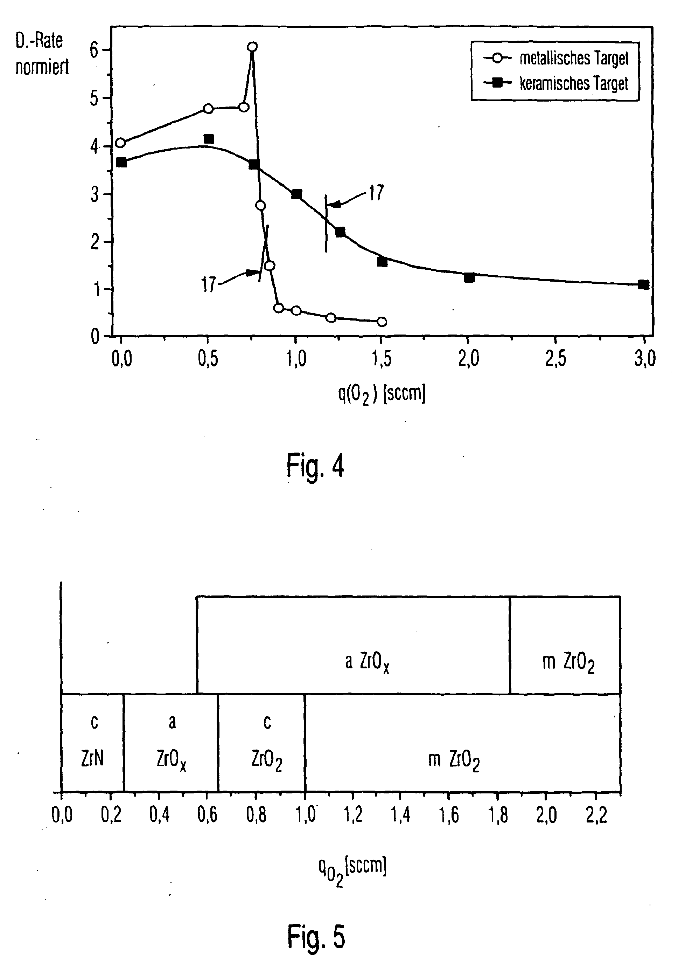

Die Fig. 4 zeigt noch einmal eine normierte Depositionsrate sowohl für ein metallisches Target als auch für ein nitridisches keramisches Target. Der gemäßigte Verlauf beim Übergang von absorbierenden zu transparenten Schichten, der wiederum durch die Trennlinien 17 verdeutlicht ist, ist darin deutlich zu erkennen. Durch Einstellen eines höheren Sauerstoffgehalts im Prozessgas wird somit erreicht, dass die Abscheiderate nur geringfügig zurückliegt, wobei gleichzeitig aber das Vorliegen einer transparenten Schicht sichergestellt werden kann. Umgekehrt kann bei einer Reduzierung des Sauerstoffanteils eine Erhöhung der Abscheiderate bewirkt werden, wobei dennoch ein stabiler Prozess einstellbar ist, da die Reaktion der Depositionsrate ebenso wie der Übergang hin zu absorbierenden Schichten aufgrund des gemäßigten Zusammenhangs leichter kontrollierbar ist. Neben den prozesstechnisch günstigeren Eigenschaften beim Sputtern von stickstoffhaltigen, keramischen Targets werden auch die Schichteigenschaften positiv beeinflusst. Beispielsweise wird für TiOₓ eine Erhöhung des Brechnungindex von n ≤ 2,4 auf n ≥ 2,5 bei einer Wellenlänge von 550 nm erreicht. Neben einer vorteilhaften Erhöhung des Brechnungsindex wird auch das Bombardement auf die abgeschiedene Schicht durch hochenergetische Sauerstoff-Ionen stark reduziert. Dieses Reduzieren des Bombardements reduziert gleichzeitig die mechanischen Spannungen. Die Verwendung eines stickstoffhaltigen Targets resultiert damit in einer Schicht geringer mechanischer Verspannung, wodurch sich eine verbesserte Haftung und damit ein beständigerer Schichtaufbau ergibt. Damit kann gleichzeitig in vorteilhafter Weise die Schichtstruktur beeinflusst werden und beispielsweise auch kubisches Zirkonoxid abgeschieden werden.

In der Fig. 5 ist ein Vergleich zwischen den erzielbaren Schichtstrukturen bei der Verwendung eines metallischen Targets (obere Hälfte) und eines stickstoffhaltigen, keramischen Targets (untere Hälfte) dargestellt. Während sich über einen großen Bereich hinsichtlich des Sauerstoffanteils im Prozessgas bei der Verwendung eines metallischen Targets amorphes Zirkonoxid (ZrOₓ) als Schicht auf dem Substrat abscheidet und bei größer werdendem Sauerstoffanteil Zirkonoxid in monokliner Phase (Bereich m) abgeschieden wird, kann mittels des erfindungsgemäßen Verfahrens auch eine kubische Phase von Zirkonoxid abgeschieden werden. Gegenüber der Verwendung von metallischen Targets ist das Intervall für den Sauerstofffluss, in dem eine amorphe Zirkonoxidphase abgeschieden wird, verkleinert. Dabei entstehen zusätzliche Intervalle, in denen das Zirkonoxid kubisch abgeschieden wird. Eine solche Beeinflussung der Kristallstruktur kann vorteilhaft eingesetzt werden, um beispielsweise die Haftfähigkeit der nachfolgenden Schichten zu verbessern. Hierzu wird die jeweils abgeschiedene Phase durch Einstellen des Sauerstoffflusses bei der Verwendung eines nitridischen Targets so eingestellt, dass sich eine Phase in der abgeschiedenen Schicht einstellt, auf der die nachfolgend aufzutragende Schicht besonders gut haftet.

Die Verwendung von nitridischen Targets hat zudem den Vorteil, dass eine zusätzliche Dotierung zum Erreichen der Leitfähigkeit des Targets nicht zwingend erforderlich ist. Die Nebengruppennitride sind meist ohnehin leitfähig, so dass auf den Zusatz von weiteren Elementen, welche sich in gegebenenfalls unerwünschter Weise ebenfalls in der Schicht einlagern, nicht erforderlich ist. Zur Durchführung des erfindungsgemäßen Verfahrens haben sich insbesondere stickstoffhaltige, keramische Targets der Zusammensetzung MeNᵤ als vorteilhaft herausgestellt, bei denen u mindestens gleich 0,2 und höchstens gleich 1,2 ist. Insbesondere zur Erzeugung von überwiegend oxidischem TiOₓN_{y} haben sich TiNᵤ-Targets mit u ≥ 0,2 und ≤ 1,2 als vorteilhaft herausgestellt, wobei die abgeschiedene Schicht eine Zusammensetzung TiOₓN_{y} mit x ≥ 1,8 und y ≤ 0,2 aufweist. Besonders bevorzugt ist es, den Sauerstofffluss in der Beschichtungskammer 7 so einzustellen, dass sich x zu mindestens 1,9 und y zu höchstens 0,1 ergibt. Wie es vorstehend bereits bei der Erläuterung der Fig. 3c angegeben wurde, ist hierzu eine entsprechende Erhöhung des Sauerstoffflusses ausreichend, da gleichzeitig mit der Erhöhung des Sauerstoffgehalts der Sauerstoffanteil in der abgeschiedenen Schicht steigt, während der Anteil des eingelagerten Stickstoffs reduziert wird.

Weitere Elemente, mit denen sich aus einem nitridischen, keramischen Target Metalloxidschichten beim Zerstäuben in sauerstoffhaltiger Atmosphäre abscheiden lassen, sind neben den bereits angegebenen Ti, Zn, Zr z. B. Hf, Nb, Si, Al oder Mischungen der Elemente.

Die Erfindung ist nicht auf die dargestellten Ausführungsbeispiele beschränkt. Vielmehr sind neben den explizit angegebenen keramischen, stickstoffhaltigen Targets von Titan, Zirkon und Zink auch die Verwendung anderer keramischer, stickstoffhaltiger Targets denkbar.

## Patentansprüche

1. Verfahren zum Herstellen eines beschichteten Gegenstands (1) mittels Kathodenzerstäuben durch Abscheiden zumindest einer überwiegend oxidischen Metalloxidschicht (3.1, 3.2, 4.1, 4.2) auf einem Substrat (2), mit folgenden Verfahrensschritten:
- Erzeugen einer sauerstoffhaltigen Sputteratmosphäre durch einen einstellbaren Sauerstofffluss
- Abscheiden der Metalloxidschicht (3.1, 3.2, 4.1, 4.2) durch Sputtern eines stickstoffhaltigen keramischen Targets (8, 9) in der sauerstoffhaltigen Sputteratmosphäre.

2. Verfahren nach Anspruch 1,
**dadurch gekennzeichnet,**
**dass** auf dem Substrat (2) zumindest eine weitere Funktionsschicht (5) abgeschieden wird, wobei unter und/oder über der weiteren Funktionsschicht (5) zumindest eine Antireflexschicht (3) abgeschieden wird, die zumindest eine Teilschicht (3.1, 3.2) enthält, die als Metalloxidschicht aus dem stickstoffhaltigen, keramischen Target (8, 9) abgeschieden wird.

3. Verfahren nach Anspruch 2,
**dadurch gekennzeichnet,**
**dass** als Funktionsschicht (5) eine infrarotreflektierende Schicht abgeschieden wird.

4. Verfahren nach einem der Ansprüche 1 bis 3,
**dadurch gekennzeichnet,**
**dass** in der Metalloxidschicht (3.1, 3.2, 4.1, 4.2) das Atomverhältnis von Sauerstoff zu Stickstoff mindestens 5 beträgt.

5. Verfahren nach einem der Ansprüche 1 bis 4,
**dadurch gekennzeichnet,**
**dass** das stickstoffhaltige keramische Target (8, 9) eines der Elemente Ti, Zn, Zr, Hf, Nb, Si, Al oder eine Mischung davon enthält.

6. Verfahren nach Anspruch 5,
**dadurch gekennzeichnet,**
**dass** das stickstoffhaltige keramische Target (8, 9) die Zusammensetzung MeNᵤ aufweist, wobei u mindestens gleich 0,2 und höchstens gleich 1,2 ist.

7. Verfahren nach einem der Ansprüche 1 bis 5,
**dadurch gekennzeichnet,**
**dass** durch Sputtern eines TiNᵤ Targets (8, 9) mit 0,2<= u <= 1,2 eine Metalloxidschicht der Zusammensetzung TiOₓN_{y} mit x >= 1,8 und y <= 0,2 abgeschieden wird.

8. Verfahren nach Anspruch 7,
**dadurch gekennzeichnet,**
**dass** durch Sputtern eines TiNᵤ Targets (8, 9) mit 0,2<= u<= 1,2 eine Metalloxidschicht der Zusammensetzung TiOₓN_{y} mit x>=1,9 und y<0,1 abgeschieden wird.

## Claims

1. Method for producing a coated article (1) by means of cathode sputtering by deposition of at least one predominantly oxidic metal oxide layer (3.1, 3.2, 4.1, 4.2) on a substrate (2), comprising the following method steps:
- production of an oxygen-containing sputtering atmosphere by an adjustable oxygen flow,
- deposition of the metal oxide layer (3.1, 3.2, 4.1, 4.2) by sputtering a nitrogen-containing ceramic target (8, 9) in the oxygen-containing sputtering atmosphere.

2. Method according to claim 1,
**characterised in that**
at least one further functional layer (5) is deposited on the substrate (2), wherein there is deposited beneath and/or above the further functional layer (5) at least one antireflection layer (3) which comprises at least one partial layer (3.1, 3.2) which is deposited as a metal oxide layer from the nitrogen-containing, ceramic target (8, 9).

3. Method according to claim 2,
**characterised in that**
an infrared-reflecting layer is deposited as the functional layer (5).

4. Method according to any one of claims 1 to 3, **characterised in that**
the atomic ratio of oxygen to nitrogen in the metal oxide layer (3.1, 3.2, 4.1, 4.2) is at least 5.

5. Method according to any one of claims 1 to 4,
**characterised in that**
the nitrogen-containing ceramic target (8, 9) comprises one of the elements Ti, Zn, Zr, Hf, Nb, Si, Al or a mixture thereof.

6. Method according to claim 5,
**characterised in that**
the nitrogen-containing ceramic target (8, 9) has the composition MeNᵤ wherein u is at least 0.2 and not more than 1.2.

7. Method according to any one of claims 1 to 5,
**characterised in that** a metal oxide layer having the composition TiOₓN_{y} wherein x >= 1.8 and y <= 0.2 is deposited by sputtering a TiNᵤ target (8, 9) wherein 0.2 <= u <= 1.2.

8. Method according to claim 7,
**characterised in that**
a metal oxide layer having the composition TiOₓN_{y} wherein x >= 1.9 and y <= 0.1 is deposited by sputtering a TiNᵤ target (8, 9) wherein 0.2 <= u <= 1.2.

## Revendications

1. Procédé pour la réalisation d'un objet (1) revêtu, au moyen de la pulvérisation cathodique par déposition d'au moins une couche d'oxyde métallique (3.1, 3.2, 4.1, 4.2) essentiellement oxyde, sur un substrat (2), comportant les étapes suivantes:
- production d'une atmosphère de pulvérisation à teneur en oxygène au moyen d'un flux d'oxygène réglable,
- déposition de la couche d'oxyde métallique (3.1, 3.2, 4.1, 4.2) par pulvérisation cathodique d'une cible (8, 9) céramique à teneur en azote, dans l'atmosphère de pulvérisation à teneur en oxygène.

2. Procédé selon la revendication 1, **caractérisé en ce que** sur le substrat (2) est déposée au moins une couche fonctionnelle (5) supplémentaire, sachant qu'au moins une couche antireflet (3) est déposée au-dessous ou au-dessus de la couche fonctionnelle (5) supplémentaire, laquelle couche antireflet contient au moins une couche partielle (3.1, 3.2) qui est déposée sous forme de couche d'oxyde métallique à partir de la cible (8, 9) céramique contenant de l'azote.

3. Procédé selon la revendication 2, **caractérisé en ce qu'**une couche réfléchissant l'infrarouge est déposée en tant que couche fonctionnelle (5).

4. Procédé selon l'une quelconque des revendications 1 à 3, **caractérisé en ce que** dans la couche d'oxyde métallique (3.1, 3.2, 4.1, 4.2), le rapport atomique entre l'oxygène et l'azote est au moins égal à 5.

5. Procédé selon l'une quelconque des revendications 1 à 4, **caractérisé en ce que** la cible (8, 9) céramique à teneur en azote contient l'un des éléments Ti, Zn, Zr, Hf, Nb, Si, Al ou un mélange de ceux-ci.

6. Procédé selon la revendication 5, **caractérisé en ce que** la cible (8, 9) céramique à teneur en azote comporte la composition MeNᵤ, dans laquelle u est au minimum égal à 0,2 et au maximum égal à 1,2.

7. Procédé selon l'une quelconque des revendications 1 à 5, **caractérisé en ce que** par la pulvérisation cathodique avec une cible (8, 9) TiNᵤ avec 0,2 ≤ u ≤ 1,2 est déposée une couche d'oxyde métallique de composition TiOₓN_{y} avec x ≥ 1,8 et y ≤ 0,2.

8. Procédé selon la revendication 7, **caractérisé en ce que** par la pulvérisation cathodique avec une cible (8, 9) TiNᵤ avec 0,2 ≤ u ≤ 1,2 est déposée une couche d'oxyde métallique de composition TiOₓN_{y} avec x ≥ 1,9 et y ≤ 0,1.
